(19) Europäisches Patentamt
European Patent Office
Office européen des brevets

(11) **EP 3 964 847 B1**

(12) **EUROPÄISCHE PATENTSCHRIFT**

(45) Veröffentlichungstag und Bekanntmachung des Hinweises auf die Patenterteilung:
**04.06.2025 Patentblatt 2025/23**

(21) Anmeldenummer: **20194799.1**

(22) Anmeldetag: **07.09.2020**

(51) Internationale Patentklassifikation (IPC):
**G01R 31/08** $^{(2020.01)}$    **H02H 3/40** $^{(2006.01)}$
**G01R 35/00** $^{(2006.01)}$    **H02H 7/26** $^{(2006.01)}$

(52) Gemeinsame Patentklassifikation (CPC):
**H02H 3/40; G01R 31/085;** G01R 31/088; H02H 7/26

(54) **KOMPENSATIONSWERTERMITTLUNGSVERFAHREN, INSBESONDERE FÜR EIN DISTANZSCHUTZVERFAHREN**

COMPENSATION VALUE CALCULATION METHOD, IN PARTICULAR FOR A DISTANCE PROTECTION METHOD

PROCÉDÉ DE DÉTERMINATION DE LA VALEUR DE COMPENSATION, EN PARTICULIER POUR UN PROCÉDÉ DE PROTECTION À DISTANCE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**09.03.2022 Patentblatt 2022/10**

(73) Patentinhaber: **Siemens Aktiengesellschaft**
**80333 München (DE)**

(72) Erfinder:
• **Dzienis, Cezary**
**14624 Dallgow-Döberitz (DE)**
• **Yelgin, Yilmaz**
**13589 Berlin (DE)**

(74) Vertreter: **Siemens Patent Attorneys**
**Postfach 22 16 34**
**80506 München (DE)**

(56) Entgegenhaltungen:
**EP-A1- 2 083 278        EP-B1- 2 937 704**
**US-A1- 2020 064 392**

• **WASHER MARIE ET AL: "Precise impedance based fault location algorithm with fault resistance separation", 2015 IEEE EINDHOVEN POWERTECH, IEEE, 29 June 2015 (2015-06-29), pages 1 - 6, XP033215617, DOI: 10.1109/ PTC.2015.7232595**

## Beschreibung

Die Erfindung bezieht sich unter anderem auf ein Distanzschutzverfahren zum Überwachen eines Leitungsabschnitts einer elektrischen Energieversorgungsleitung, bei dem Strom- und Spannungswerte gemessen werden, zumindest ein Impedanz- oder Reaktanzwert unter Heranziehung zumindest eines Kompensationswertes ermittelt wird und ein Fehlersignal erzeugt wird, wenn der Impedanz- oder Reaktanzwert ein vorgegebenes Auslösekriterium erfüllt, insbesondere in einem vorgegebenen Auslösebereich liegt. Derartige Distanzschutzverfahren, die auf der sogenannten Reaktanzmethode basieren, sind beispielsweise in der europäischen Patentschrift EP 2 937 704 B1 beschrieben. Ein weiteres Distanzschutzverfahren ist in der europäischen Patentanmeldung EP 2 083 278 A1 beschrieben.

Das aus der genannten Patentschrift vorbekannte Distanzschutzverfahren verlangt die Eingabe eines für die Anwendung der Reaktanzmethode erforderlichen Kompensationswertes, der abhängig von der jeweils zu überwachenden Energieversorgungsleitung und deren Betriebs- bzw. Einspeisesituation ist.

Der Erfindung liegt die Aufgabe zugrunde, ein Distanzschutzverfahren anzugeben, das mit Blick auf die für die Reaktanzmethode vorzugebenden Kompensationswerte besonders bedienerfreundlich ist.

Diese Aufgabe wird erfindungsgemäß durch ein Distanzschutzverfahren mit den Merkmalen gemäß Patentanspruch 1 gelöst. Vorteilhafte Ausgestaltungen des erfindungsgemäßen Distanzschutzverfahrens sind in Unteransprüchen angegeben.

Danach ist erfindungsgemäß vorgesehen, dass als der zumindest eine Kompensationswert oder als zumindest einer der Kompensationswerte ein zurückgerechneter Kompensationswert verwendet wird, der anhand von Messdaten, die bei einem früheren auf der Energieversorgungsleitung aufgetretenen Fehler erfasst worden sind oder einem aktuellen auf der Energieversorgungsleitung aufgetretenen Fehler erfasst werden, ermittelt worden ist.

Ein wesentlicher Vorteil des erfindungsgemäßen Distanzschutzverfahrens ist darin zu sehen, dass bei diesem keine bedienerseitige Ermittlung und Eingabe von Kompensationswerten erforderlich ist, da die Kompensationswerte automatisch durch Rückrechnung ermittelt werden, sei es auf der Basis historischer Fehlerdaten vor Eintritt eines aktuellen Fehlers oder auf der Basis aktueller Fehlerdaten während eines aktuellen Fehlerereignisses.

Es ist erfindungsgemäß vorgesehen, wenn der zumindest eine zurückgerechnete Kompensationswert oder mindestens einer der zurückgerechneten Kompensationswerte ermittelt worden ist durch einen Vergleich einer errechneten Fehlereigenschaft, die für einen oder mehrere Hilfskompensationswerte berechnet worden ist, mit der bei dem früheren oder aktuellen auf der Energieversorgungsleitung aufgetretenen Fehler tatsächlich festgestellten Fehlereigenschaft und durch Auswahl desjenigen Hilfskompensationswerts, dessen Fehlereigenschaft die kleinste Abweichung von der tatsächlich festgestellten Fehlereigenschaft aufweist, als zukünftig zu verwendender zurückgerechneter Kompensationswert.

Besonders einfach und damit vorteilhaft lässt sich das Verfahren durchführen, wenn der zumindest eine zurückgerechnete Kompensationswert oder mindestens einer der zurückgerechneten Kompensationswerte ermittelt worden ist durch ein Iterationsverfahren, bei dem im Rahmen von Iterationsschritten für jeden Iterationsschritt jeweils ein Hilfskompensationswert festgelegt wird, und als Iterationsergebnis derjenige Hilfskompensationswert ermittelt wird, dessen Fehlereigenschaft die kleinste Abweichung von der tatsächlich festgestellten Fehlereigenschaft aufweist, und dieses Iterationsergebnis als zukünftig zu verwendender zurückgerechneter Kompensationswert weiterverwendet wird.

Als Fehlereigenschaft werden bevorzugt quantifizierbare Fehlereigenschaften herangezogen. Eine besonders geeignete Fehlereigenschaft ist der Fehlerabstand, beispielsweise der Fehlerabstand zwischen einem das Distanzschutzverfahren ausführenden Distanzschutzgerät und der Fehlerstelle.

Bei der letztgenannten Ausführungsvariante ist es vorteilhaft, wenn der zumindest eine zurückgerechnete Kompensationswert oder mindestens einer der zurückgerechneten Kompensationswerte ermittelt worden ist durch einen Vergleich eines oder mehrerer errechneter Fehlerabstandswerte, die für einen oder mehrere Hilfskompensationswerte berechnet worden sind, mit dem bei dem früheren oder aktuellen auf der Energieversorgungsleitung aufgetretenen Fehler tatsächlich festgestellten Fehlerabstandswert und durch Auswahl desjenigen Hilfskompensationswerts, dessen errechneter Fehlerabstandswert die kleinste Abweichung von dem tatsächlich festgestellten Fehlerabstandswert aufweist, als zukünftig zu verwendender zurückgerechneter Kompensationswert.

Besonders vorteilhaft ist es, wenn anhand der Messdaten, die bei einem früheren oder aktuellen auf der Energieversorgungsleitung aufgetretenen Fehler erfasst und gespeichert worden sind, zumindest zwei zurückgerechnete Kompensationswerte ermittelt werden, nämlich ein auf das Nullsystem bezogener erster Kompensationswert und ein auf das Gegensystem bezogener zweiter Kompensationswert.

Der erste und zweite zurückgerechnete Kompensationswert sind vorzugsweise jeweils ermittelt worden durch einen Vergleich einer errechneten Fehlereigenschaft, die für einen oder mehrere Hilfskompensationswerte berechnet worden ist, mit der bei dem früheren oder aktuellen auf der Energieversorgungsleitung aufgetretenen Fehler tatsächlich festgestellten Fehlereigenschaft und durch Auswahl desjenigen Hilfskompensationswerts, dessen Fehlereigenschaft die kleinste Abweichung von der tatsächlich festgestellten Fehlereigenschaft aufweist, als zukünftig zu verwendender zurückgerechneter Kompensationswert.

Besonders vorteilhaft ist es, wenn der erste und zweite zurückgerechnete Kompensationswert jeweils ermittelt worden sind durch einen Vergleich eines oder mehrerer errechneter Fehlerabstandswerte, die für einen oder mehrere Hilfskompensationswerte berechnet worden sind, mit dem bei dem früheren oder aktuellen auf der Energieversorgungsleitung aufgetretenen Fehler tatsächlich festgestellten Fehlerabstandswert und durch Auswahl desjenigen Hilfskompensationswerts, dessen errechneter Fehlerabstandswert die kleinste Abweichung von dem tatsächlich festgestellten Fehlerabstandswert aufweist, als zukünftig zu verwendender zurückgerechneter Kompensationswert.

Die Erfindung bezieht sich außerdem auf ein Kompensationswertermittlungsverfahren zum Ermitteln zumindest eines Kompensationswertes für ein Distanzschutzverfahren wie oben beschrieben. Erfindungsgemäß ist bezüglich eines solchen Kompensationswertermittlungsverfahrens vorgesehen, dass der zumindest eine Kompensationswert anhand von Messdaten, die bei einem früheren oder aktuellen auf der Energieversorgungsleitung aufgetretenen Fehler erfasst (und vorzugsweise gespeichert) worden sind, ermittelt wird.

Bezüglich der Vorteile des erfindungsgemäßen Kompensationswertermittlungsverfahrens sowie vorteilhafter Ausgestaltungen des erfindungsgemäßen Kompensationswertermittlungsverfahrens sei auf die obigen Ausführungen im Zusammenhang mit dem erfindungsgemäßen Distanzschutzverfahren sowie dessen vorteilhafter Ausgestaltungen verwiesen.

Bei dem erfindungsgemäßen Kompensationswertermittlungsverfahren wird der Kompensationswert ermittelt durch einen Vergleich einer errechneten Fehlereigenschaft, die für einen oder mehrere Hilfskompensationswerte berechnet worden ist, mit der bei dem früheren oder aktuellen auf der Energieversorgungsleitung aufgetretenen Fehler tatsächlich festgestellten Fehlereigenschaft und der Auswahl desjenigen Hilfskompensationswerts, dessen Fehlereigenschaft die kleinste Abweichung von der tatsächlich festgestellten Fehlereigenschaft aufweist, als ermittelter Kompensationswert.

Der Kompensationswert wird bei dem Kompensationswertermittlungsverfahren vorzugsweise ermittelt durch einen Vergleich eines oder mehrerer errechneter Fehlerabstandswerte, die für einen oder mehrere Hilfskompensationswerte berechnet worden sind, mit dem bei dem früheren oder aktuellen auf der Energieversorgungsleitung aufgetreten Fehler tatsächlich festgestellten Fehlerabstandswert und der Auswahl desjenigen Hilfskompensationswerts, dessen errechneter Fehlerabstandswert die kleinste Abweichung von dem tatsächlich festgestellten Fehlerabstandswert aufweist, als den ermittelten Kompensationswert.

Bei dem Kompensationswertermittlungsverfahren werden die zurückgerechneten Kompensationswerte für den Fall eines einphasigen Leiter-Erde-Fehlers im x-ten Phasenleiter der Energieversorgungsleitung vorzugsweise jeweils derart berechnet, dass die Abweichung zwischen dem korrespondierenden Fehlerabstandswert m und dem tatsächlich festgestellten Fehlerabstandswert Msoll minimal ist bzw. gilt:

$$m = \frac{1}{|Z|} \cdot \frac{\operatorname{Im}\left\{Ulx \cdot \left[Is \cdot e^{j\delta}\right]^*\right\}}{\operatorname{Im}\left\{\frac{Z}{|Z|} \cdot (Ilx - k0 \cdot Ie) \cdot \left[Is \cdot e^{j\delta}\right]^*\right\}} \overset{!}{=} Msoll$$

wobei bezeichnet:

- m den jeweiligen errechneten Fehlerabstandswert für den jeweiligen Hilfskompensationswert $\delta$ in Form eines prozentualen Anteils an der Gesamtlänge L des überwachten Leitungsabschnitts,
- Ilx den Leiterstrom als Zeigergröße im x-ten Phasenleiter der Energieversorgungsleitung,
- Ulx die Leiter-Erde-Spannung des x-ten Phasenleiters der Energieversorgungsleitung als Zeigergröße,
- Z die Leitungsimpedanz des überwachten Leitungsabschnitts der elektrischen Energieversorgungsleitung,
- Is einen Ersatzstrom,
- k0 einen für die elektrischen Energieversorgungsleitung charakteristischen Erdanpassungsfaktor und
- Msoll den tatsächlich festgestellten Fehlerabstandswert in Form eines prozentualen Anteils an der Gesamtlänge L des überwachten Leitungsabschnitts.

Der Ersatzstrom Is wird vorzugsweise wie folgt berechnet:

$$Is = \frac{1}{3}(Ilx + Ily + Ilz)$$

für die Hilfskompensationswerte des Nullsystems und

$$Is = \frac{1}{3}(Ilx + a^2 \cdot Ily + a \cdot Ilz) \quad \texttt{mit} \quad a = e^{j2\pi/3}$$

für die Hilfskompensationswerte des Gegensystems.

Die tatsächlich festgestellten Fehlerabstandswerte Msoll können beispielsweise durch Inspektion der Leitung nach einem Fehler, durch eine zweiseitige Fehlerortung oder mittels Wanderwellenfehlerortung ermittelt werden.

Im Falle eines Leiter-Leiter-Fehlers zwischen dem x-ten und y-ten Phasenleiter der Energieversorgungsleitung werden die zurückgerechneten Kompensationswerte vorzugsweise jeweils derart berechnet, dass die Abweichung zwischen dem korrespondierenden Fehlerabstandswert m und dem tatsächlich festgestellten Fehlerabstandswert Msoll minimal ist bzw. gilt:

$$m = \frac{1}{|Z|} \cdot \frac{\mathrm{Im}\left\{ Ulxy \cdot \left[ Is \cdot e^{j\delta} \right]^* \right\}}{\mathrm{Im}\left\{ \frac{Z}{|Z|} \cdot (Ilx - Ily) \cdot \left[ Is \cdot e^{j\delta} \right]^* \right\}} \overset{!}{=} Msoll$$

wobei bezeichnet:

- Ilx den Leiterstrom als Zeigergröße im x-ten Phasenleiter der Energieversorgungsleitung,
- Ily den Leiterstrom als Zeigergröße im y-ten Phasenleiter der Energieversorgungsleitung und
- Ulxy die Leiter-Leiter-Spannung als Zeigergröße zwischen dem x-ten und y-ten Phasenleiter der Energieversorgungsleitung,

Die Erfindung bezieht sich außerdem auf eine Kompensationswertbestimmungseinrichtung zum Ermitteln zumindest eines Kompensationswertes für ein Distanzschutzverfahren wie oben beschrieben oder ein Distanzschutzgerät, das ein Distanzschutzverfahren wie oben beschrieben ausführen kann. Erfindungsgemäß ist vorgesehen, dass die Kompensationswertbestimmungseinrichtung derart ausgestaltet ist, dass sie den zumindest einen Kompensationswert anhand von Messdaten, die bei einem früheren auf der Energieversorgungsleitung aufgetretenen Fehler erfasst worden sind oder einem aktuellen auf der Energieversorgungsleitung aufgetretenen Fehler erfasst werden, ermittelt.

Bezüglich der Vorteile der erfindungsgemäßen Kompensationswertbestimmungseinrichtung sowie vorteilhafter Ausgestaltungen der erfindungsgemäßen Kompensationswertbestimmungseinrichtung sei auf die obigen Ausführungen verwiesen. Vorteilhaft ist insbesondere, dass die Kompensationswertbestimmungseinrichtung die Kompensationswerte automatisch berechnen kann, beispielsweise auch während des laufenden Betriebs eines Distanzschutzgeräts, in dem die Kompensationswertbestimmungseinrichtung integriert sein kann.

Die Erfindung bezieht sich außerdem auf eine Distanzschutzeinrichtung. Erfindungsgemäß ist vorgesehen, dass diese eine Kompensationswertbestimmungseinrichtung wie oben beschrieben aufweist.

Die Erfindung wird nachfolgend anhand von Ausführungsbeispielen näher erläutert; dabei zeigen beispielhaft

Figur 1    ein Ausführungsbeispiel für ein erfindungsgemäßes Distanzschutzgerät, anhand dessen ein erstes Ausführungsbeispiel für ein erfindungsgemäßes Verfahren erläutert wird, und

Figur 2    ein weiteres Ausführungsbeispiel für ein erfindungsgemäßes Distanzschutzgerät, anhand dessen ein zweites Ausführungsbeispiel für ein erfindungsgemäßes Verfahren erläutert wird.

In den Figuren werden für identische oder vergleichbare Komponenten stets dieselben Bezugszeichen verwendet.

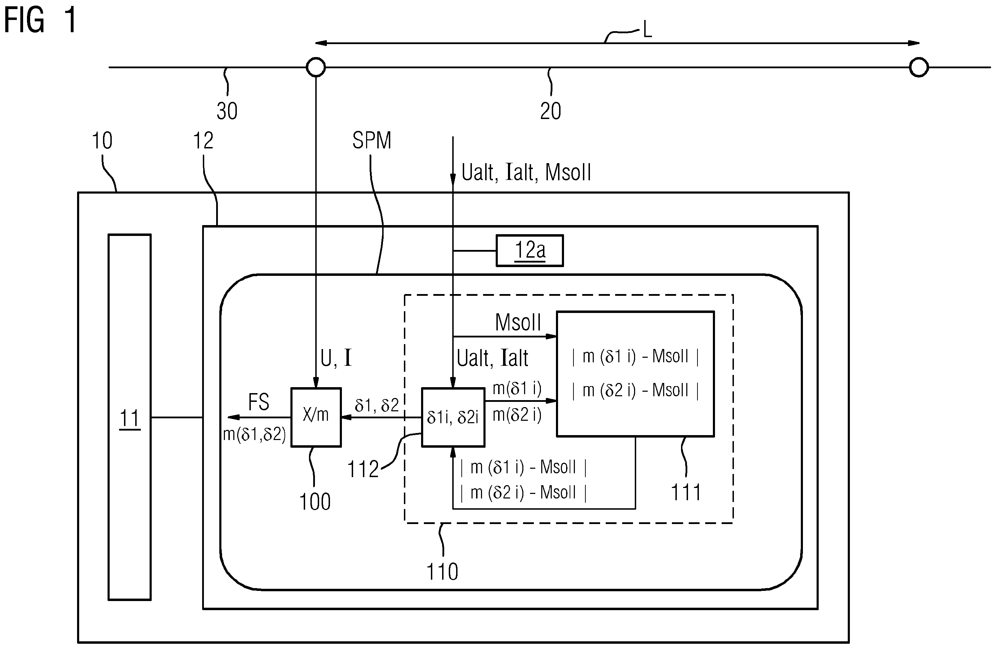

Die Figur 1 zeigt ein Ausführungsbeispiel für ein Distanzschutzgerät 10, das zum Überwachen eines Leitungsabschnitts 20 einer elektrischen Energieversorgungsleitung 30 geeignet ist und mit einer internen Kompensationswertbestimmungsfunktion ausgestattet ist.

Das Distanzschutzgerät 10 umfasst eine Recheneinrichtung 11 und einen Speicher 12, in dem ein Softwareprogrammprodukt SPM abgespeichert ist, das bei Ausführung durch die Recheneinrichtung 11 die Arbeitsweise des Distanzschutzgeräts 10 bestimmt.

Das Softwareprogrammprodukt SPM umfasst ein Fehlersignalerzeugungsmodul 100, das bei Ausführung durch die Recheneinrichtung 11 eine Fehlersignalerzeugungseinrichtung bildet. Das Fehlersignalerzeugungsmodul 100 ist dazu ausgebildet, aktuelle Betriebsdaten, beispielsweise in Form von Spannungs- und Stromwerten U und I, auszuwerten und unter Heranziehung eines zurückgerechneten Kompensationswerts $\delta 1$ oder $\delta 2$ eine Fehlerimpedanz oder zumindest eine Fehlerreaktanz X zu bestimmen. Liegt die Fehlerimpedanz oder die Fehlerreaktanz X innerhalb eines vorgegebenen Auslösebereichs, so wird ein Fehlersignal FS erzeugt. Bezüglich der Berechnung einer Fehlerreaktanz X unter Einbezug von Kompensationswerten $\delta1$ bzw. $\delta2$ können die Erläuterungen in der eingangs bereits erwähnten Patentschrift EP 2 937 704 B1 herangezogen werden, in der Berechnungsformeln für die Fehlerreaktanz X für unterschiedliche Fehler im Einzelnen beschrieben sind.

Außerdem kann das Fehlersignalerzeugungsmodul 100 im Falle eines festgestellten Fehlers einen relativen Fehlerabstandswert m($\delta1$, $\delta2$) beispielsweise in Form eines prozentualen Anteils an der Gesamtlänge L des überwachten Leitungsabschnitts 20 ausgeben.

Das Softwareprogrammprodukt SPM umfasst außerdem ein Kompensationswertbestimmungsmodul 110, das bei Ausführung durch die Recheneinrichtung 11 eine Kompensationswertbestimmungseinrichtung bildet und einen ersten, auf das Nullsystem der Energieversorgungsleitung 30 bezogenen zurückgerechneten Kompensationswert $\delta1$ und einen zweiten, auf das Gegensystem der Energieversorgungsleitung 30 bezogenen zurückgerechneten Kompensationswert $\delta2$ ermitteln kann. Von den zwei zurückgerechneten Kompensationswerten $\delta1$ und $\delta2$ wählt das Kompensationswertbestimmungsmodul 110 einen aus und überträgt diesen zum Fehlersignalerzeugungsmodul 100 zur weiteren Verwendung, insbesondere zur Bestimmung der Fehlerreaktanz X und des relativen Fehlerabstandswerts m($\delta1$, $\delta2$).

Das Kompensationswertbestimmungsmodul 110 umfasst ein Vergleichsmodul 111 und ein Iterationsmodul 112. Das Iterationsmodul 112 und das Vergleichsmodul 111 führen gemeinsam ein Iterationsverfahren durch.

Im Rahmen des Iterationsverfahrens wird bezogen auf das Nullsystem und bezogen auf das Gegensystem jeweils ein optimaler Kompensationswert $\delta1$ und $\delta2$ rückgerechnet, und zwar anhand von Messdaten, vorzugsweise Strom- und Spannungsmesswerten Ialt und Ualt, die bei einem früheren auf der Energieversorgungsleitung 30 aufgetretenen Fehler erfasst worden sind. Die Rückrechnung der Kompensationswerte $\delta1$ und $\delta2$ erfolgt bezogen auf zumindest eine quantifizierbare Fehlereigenschaft des früher aufgetretenen Fehlers; nachfolgend wird beispielhaft davon ausgegangen, dass der relative Fehlerabstand als quantifizierbare Fehlereigenschaft herangezogen wird. Msoll bezeichnet nachfolgend den bei dem früheren auf der Energieversorgungsleitung 30 aufgetretenen Fehler tatsächlich festgestellten Fehlerabstandswert in Form eines prozentualen Anteils an der Gesamtlänge L des überwachten Leitungsabschnitts 20.

Die Strom- und Spannungsmesswerte Ialt und Ualt, die bei dem früher auf der Energieversorgungsleitung 30 aufgetretenen Fehler erfasst worden sind, können zur Durchführung des Iterationsverfahrens gezielt von außen eingespeist werden; alternativ können diese auch aus einem Speicherbereich 12a des Speichers 12 ausgelesen werden, sofern sie in diesem zwischengespeichert worden sind.

In jedem i-ten Iterationsschritt des Iterationsverfahrens wird für den ersten und zweiten Kompensationswert $\delta1$ und $\delta2$ jeweils individuell ein Hilfskompensationswert $\delta1i$ und $\delta2i$ festgelegt, für den ein korrespondierender relativer Fehlerabstandswert m($\delta1i$) und m($\delta2i$) - auf der Basis eines die Energieversorgungsleitung 30 bzw. deren Leitungsabschnitt 20 beschreibenden Leitungsmodells - hilfskompensationswertindividuell errechnet wird. Anschließend werden die hilfskompensationswertindividuell errechneten Fehlerabstandswerte m($\delta1i$) und m($\delta2$) mit dem bei dem früher auf der Energieversorgungsleitung 30 aufgetretenen Fehler tatsächlich festgestellten Fehlerabstandswert Msoll unter Bildung eines Abweichungswertes |m($\delta1i$)-Msoll| bzw. |m($\delta2i$)-Msoll| verglichen. Ausgewählt wird für den ersten und zweiten Kompensationswert als finaler rückgerechneter Kompensationswert $\delta1$ und $\delta2$ jeweils derjenige Hilfskompensationswert $\delta1i$ und $\delta2i$, dessen errechneter Fehlerabstandswert m($\delta1i$) bzw. m($\delta2i$) die kleinste Abweichung von dem tatsächlich festgestellten Fehlerabstandswert Msoll aufweist.

Von den beiden finalen rückgerechneten Kompensationswerten $\delta1$ und $\delta2$ wird schließlich derjenige Kompensationswert ausgewählt, dessen rückgerechneter Fehlerabstandswert die kleinere Abweichung von dem tatsächlich festgestellten Fehlerabstandswert Msoll aufweist; dieser ausgewählte Kompensationswert $\delta1$ oder $\delta2$ wird als zukünftig zu verwendender zurückgerechneter Kompensationswert an das Fehlersignalerzeugungsmodul 100 zur Weiterverwendung weitergeleitet.

Für den Fall eines einphasigen Leiter-Erde-Fehlers im x-ten Phasenleiter der Energieversorgungsleitung 30 werden die Fehlerabstandswerte vorzugsweise jeweils berechnet gemäß:

$$m(\delta) = \frac{1}{|Z|} \cdot \frac{\text{Im}\left\{Ulx \cdot \left[Is \cdot e^{j\delta}\right]^{*}\right\}}{\text{Im}\left\{\frac{Z}{|Z|} \cdot (Ilx - k0 \cdot Ie) \cdot \left[Is \cdot e^{j\delta}\right]^{*}\right\}} \quad \text{mit } \delta=\delta1i \text{ bzw. } \delta=\delta2i$$

wobei m den jeweiligen errechneten Fehlerabstandswert für den jeweiligen Hilfskompensationswert $\delta1i$ bzw. $\delta2i$ in Form eines prozentualen Anteils an der Gesamtlänge L des überwachten Leitungsabschnitts 20 bezeichnet. Ilx bezeichnet den Leiterstrom als Zeigergröße im x-ten Phasenleiter der Energieversorgungsleitung 30, Ulx die Leiter-Erde-Spannung des x-ten Phasenleiters der Energieversorgungsleitung 30 als Zeigergröße, Z die Leitungsimpedanz des überwachten Leitungsabschnitts 20 der elektrischen Energieversorgungsleitung 30, Is einen Ersatzstrom und k0 einen für die elektrische Energieversorgungsleitung 30 charakteristischen Erdanpassungsfaktor.

Der Ersatzstrom Is wird vorzugsweise wie folgt berechnet:

$$Is = \frac{1}{3}(Ilx + Ily + Ilz)$$

für die Hilfskompensationswerte $\delta 1i$ des Nullsystems und

$$Is = \frac{1}{3}(Ilx + a^2 \cdot Ily + a \cdot Ilz) \quad \text{mit} \quad a = e^{j2\pi/3}$$

für die Hilfskompensationswerte $\delta 2i$ des Gegensystems.

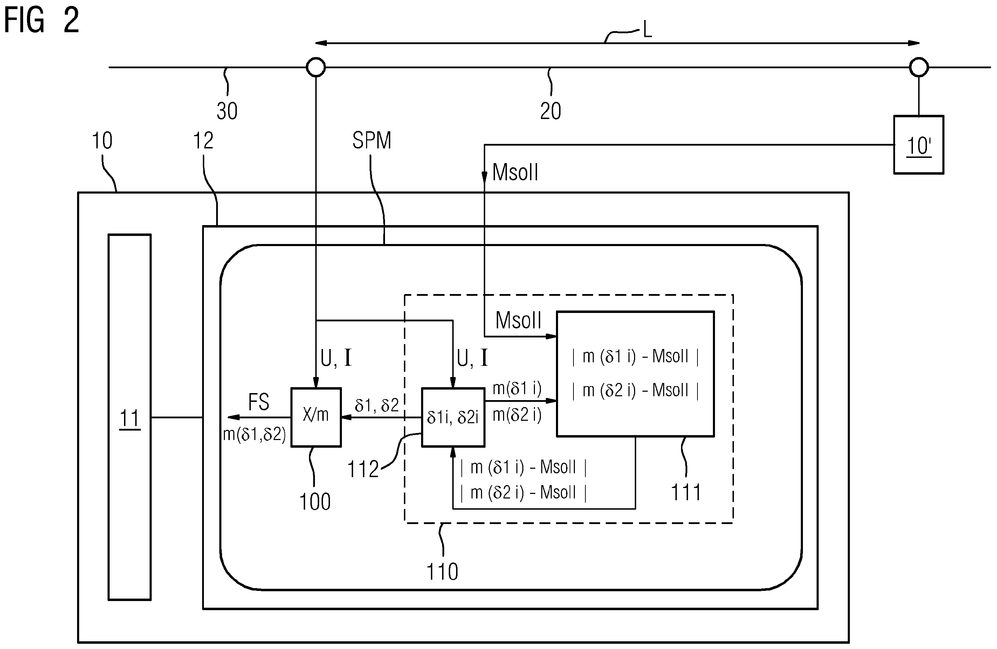

Die Figur 2 zeigt ein weiteres Ausführungsbeispiel für ein Distanzschutzgerät 10, das zum Überwachen eines Leitungsabschnitts 20 einer elektrischen Energieversorgungsleitung 30 geeignet ist und mit einer internen Kompensationswertbestimmungsfunktion ausgestattet ist. Bei dem Ausführungsbeispiel gemäß Figur 2 steht das Distanzschutzgerät 10 mit einer anderen Einrichtung, beispielsweise einem an dem anderen Leitungsende des Leitungsabschnitts 20 angeschlossenen anderen Distanzschutzgerät 10', in Verbindung und erhält von diesem - bei Feststellung eines Fehlers im Leitungsabschnitt 20 - einen aktuellen, von dem anderen Distanzschutzgerät 10' ermittelten, also extern ermittelten, Fehlerabstandswert Msoll, der sich auf den aktuellen, also während des normalen Überwachungsbetrieb des Distanzschutzgeräts 10 auftretenden Fehler bezieht.

Das Distanzschutzgerät 10 wertet mittels seines Kompensationswertbestimmungsmoduls 110 die aktuellen Betriebsdaten, beispielsweise in Form von Spannungs- und Stromwerten U und I, unter Heranziehung des aktuell extern ermittelten Fehlerabstandswert Msoll und des im Zusammenhang mit Figur 1 erläuterten Leitungsmodells aus, um zurückgerechnete Kompensationswerte $\delta 1$ und $\delta 2$ zu bestimmen und einen davon für das Fehlersignalerzeugungsmodul 100 auszuwählen.

Die Arbeitsweise des Kompensationswertbestimmungsmoduls 110 gemäß Figur 2 kann der Arbeitsweise des Kompensationswertbestimmungsmoduls 110 gemäß Figur 1 entsprechen; anders als in Figur 1 werden lediglich nicht alte Strom- und Spannungsemsswerte Ialt und Ualt eines früheren Fehlers herangezogen, sondern die aktuellen Strom- und Spannungsmesswerte U und I des aktuell vorliegenden Fehlers.

Mit anderen Worten unterscheidet sich die Ausführungsvariante gemäß Figur 2 von der Ausführungsvariante gemäß Figur 1 dadurch, dass im laufenden Betrieb eine automatische Neuberechnung von optimalen Kompensationswerten anhand aktueller Fehler erfolgen kann, wohingegen bei der Ausführungsvariante gemäß Figur 1 auf frühere, also alte Fehler zurückgegriffen wird.

Selbstverständlich kann auch - im Sinne einer dritten Ausführungsvariante - ein Distanzschutzgerät 10 vorgesehen werden, das eine erste Berechnung von optimalen Kompensationswerten anhand eines alten Fehlers gemäß Figur 1 ermöglicht und anschließend im laufenden Betrieb eine automatische Neuberechnung von optimalen Kompensationswerten anhand aktueller Fehler gemäß Figur 2 durchführt.

Obwohl die Erfindung im Detail durch bevorzugte Ausführungsbeispiele näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung wie in den Ansprüchen definiert zu verlassen.

Bezugszeichenliste

| | |
|---|---|
| 10 | Distanzschutzgerät |
| 10' | Distanzschutzgerät |
| 11 | Recheneinrichtung |
| 12 | Speicher |
| 12a | Speicherbereich |
| 20 | Leitungsabschnitt |
| 30 | elektrische Energieversorgungsleitung |
| 100 | Fehlersignalerzeugungsmodul |
| 110 | Kompensationswertbestimmungsmodul |
| 111 | Vergleichsmodul |
| 112 | Iterationsmodul |

| | |
|---|---|
| FS | Fehlersignal |
| I | Stromwerte |
| Ialt | Strommesswert |
| L | Gesamtlänge |
| $m(\delta1, \delta2)$ | relativer Fehlerabstandswert |
| $m(\delta1i)$ | relativer Fehlerabstandswert |
| $m(\delta2i)$ | relativer Fehlerabstandswert |
| $|m(\delta1i)\text{-Msoll}|$ | Abweichungswert |
| $|m(\delta2i)\text{-Msoll}|$ | Abweichungswert |
| Msoll | tatsächlich festgestellter Fehlerabstandswert |
| SPM | Softwareprogrammprodukt |
| U | Spannungswerte |
| Ualt | Spannungsmesswert |
| X | Fehlerreaktanz(wert) |
| | |
| $\delta1$ | Kompensationswert |
| $\delta2$ | Kompensationswert |
| $\delta1i$ | Hilfskompensationswert |
| $\delta2i$ | Hilfskompensationswert |

**Patentansprüche**

1. Distanzschutzverfahren zum Überwachen eines Leitungsabschnitts (20) einer elektrischen Energieversorgungsleitung (30), bei dem

    - Strom- und Spannungswerte (I, U) gemessen werden und ein Impedanz- oder Reaktanzwert (X) der Energieversorgungsleitung (30) unter Heranziehung zumindest eines Kompensationswertes ($\delta1$, $\delta2$) ermittelt wird und
    - ein Fehlersignal (FS) erzeugt wird, wenn der Impedanz- oder Reaktanzwert (X) ein vorgegebenes Auslösekriterium erfüllt, wobei, dass als der zumindest eine Kompensationswert ($\delta1$, $\delta2$) oder als zumindest einer der Kompensationswerte ($\delta1$, $\delta2$) ein zurückgerechneter Kompensationswert verwendet wird, der anhand von Messdaten, die bei einem früheren auf der Energieversorgungsleitung (30) aufgetretenen Fehler erfasst worden sind oder einem aktuellen auf der Energieversorgungsleitung (30) aufgetretenen Fehler erfasst werden, ermittelt worden ist, **dadurch gekennzeichnet, dass** der zumindest eine zurückgerechnete Kompensationswert ($\delta1$, $\delta2$) oder mindestens einer der zurückgerechneten Kompensationswerte ermittelt worden ist
    - durch einen Vergleich einer errechneten Fehlereigenschaft, die für einen oder mehrere Hilfskompensationswerte ($\delta1i$, $\delta2i$) berechnet worden ist, mit der bei dem früheren oder aktuellen auf der Energieversorgungsleitung (30) aufgetretenen Fehler tatsächlich festgestellten Fehlereigenschaft und
    - durch Auswahl desjenigen Hilfskompensationswerts ($\delta1i$, $\delta2i$), dessen Fehlereigenschaft die kleinste Abweichung von der tatsächlich festgestellten Fehlereigenschaft aufweist, als zukünftig zu verwendender zurückgerechneter Kompensationswert.

2. Distanzschutzverfahren nach einem der voranstehenden Ansprüche,
    **dadurch gekennzeichnet, dass** der zumindest eine zurückgerechnete Kompensationswert ($\delta1$, $\delta2$) oder mindestens einer der zurückgerechneten Kompensationswerte ermittelt worden ist

    - durch ein Iterationsverfahren, bei dem im Rahmen von Iterationsschritten für jeden Iterationsschritt jeweils ein Hilfskompensationswert ($\delta1i$, $\delta2i$) bestimmt wird, und
    - als Iterationsergebnis derjenige Hilfskompensationswert ($\delta1i$, $\delta2i$) ermittelt wird, dessen Fehlereigenschaft die kleinste Abweichung von der tatsächlich festgestellten Fehlereigenschaft aufweist, und dieses Iterationsergebnis als zukünftig zu verwendender zurückgerechneter Kompensationswert weiterverwendet wird.

3. Distanzschutzverfahren nach einem der voranstehenden Ansprüche,
    **dadurch gekennzeichnet, dass** der zumindest eine zurückgerechnete Kompensationswert ($\delta1$, $\delta2$) oder mindestens einer der zurückgerechneten Kompensationswerte ermittelt worden ist

    - durch einen Vergleich eines oder mehrerer errechneter Fehlerabstandswerte ($m(\delta1i)$, $m(\delta2i)$), die für einen oder mehrere Hilfskompensationswerte ($\delta1i$, $\delta2i$) berechnet worden sind, mit dem bei dem früheren oder aktuellen auf der Energieversorgungsleitung (30) aufgetretenen Fehler tatsächlich festgestellten Fehlerabstandswert (Msoll) und

- durch Auswahl desjenigen Hilfskompensationswerts, dessen errechneter Fehlerabstandswert die kleinste Abweichung von dem tatsächlich festgestellten Fehlerabstandswert aufweist, als zukünftig zu verwendender zurückgerechneter Kompensationswert.

4. Distanzschutzverfahren nach einem der voranstehenden Ansprüche,
**dadurch gekennzeichnet, dass** anhand der Messdaten, die bei einem früheren oder aktuellen auf der Energieversorgungsleitung (30) aufgetretenen Fehler erfasst und gespeichert worden sind, zumindest zwei zurückgerechnete Kompensationswerte ermittelt werden, nämlich ein auf das Nullsystem bezogener erster Kompensationswert und ein auf das Gegensystem bezogener zweiter Kompensationswert.

5. Distanzschutzverfahren nach Anspruch 4,
**dadurch gekennzeichnet, dass** der erste und zweite zurückgerechnete Kompensationswert jeweils ermittelt worden sind

- durch einen Vergleich einer errechneten Fehlereigenschaft, die für einen oder mehrere Hilfskompensationswerte berechnet worden ist, mit der bei dem früheren oder aktuellen auf der Energieversorgungsleitung (30) aufgetretenen Fehler tatsächlich festgestellten Fehlereigenschaft und
- durch Auswahl desjenigen Hilfskompensationswerts, dessen Fehlereigenschaft die kleinste Abweichung von der tatsächlich festgestellten Fehlereigenschaft aufweist, als zukünftig zu verwendender zurückgerechneter Kompensationswert.

6. Distanzschutzverfahren nach einem der voranstehenden Ansprüche,
**dadurch gekennzeichnet, dass** der erste und zweite zurückgerechnete Kompensationswert jeweils ermittelt worden sind

- durch einen Vergleich eines oder mehrerer errechneter Fehlerabstandswerte, die für einen oder mehrere Hilfskompensationswerte berechnet worden sind, mit dem bei dem früheren oder aktuellen auf der Energieversorgungsleitung (30) aufgetretenen Fehler tatsächlich festgestellten Fehlerabstandswert und
- durch Auswahl desjenigen Hilfskompensationswerts, dessen errechneter Fehlerabstandswert die kleinste Abweichung von dem tatsächlich festgestellten Fehlerabstandswert aufweist, als zukünftig zu verwendender zurückgerechneter Kompensationswert.

7. Kompensationswertermittlungsverfahren zum Ermitteln zumindest eines Kompensationswertes für ein Distanzschutzverfahren nach einem der voranstehenden Ansprüche,
wobei der zumindest eine Kompensationswert anhand von Messdaten, die bei einem früheren auf der Energieversorgungsleitung (30) aufgetretenen Fehler erfasst worden sind oder bei einem aktuellen auf der Energieversorgungsleitung (30) aufgetretenen Fehler erfasst werden, ermittelt wird, **dadurch gekennzeichnet, dass** der Kompensationswert ermittelt wird

- durch einen Vergleich einer errechneten Fehlereigenschaft, die für einen oder mehrere Hilfskompensationswerte berechnet worden ist, mit der bei dem früheren oder aktuellen auf der Energieversorgungsleitung (30) aufgetretenen Fehler tatsächlich festgestellten Fehlereigenschaft und
- der Auswahl desjenigen Hilfskompensationswerts, dessen Fehlereigenschaft die kleinste Abweichung von der tatsächlich festgestellten Fehlereigenschaft aufweist, als ermittelter Kompensationswert.

8. Kompensationswertermittlungsverfahren nach einem der voranstehenden Ansprüche 6 bis 7,
**dadurch gekennzeichnet, dass** der Kompensationswert ermittelt wird

- durch einen Vergleich eines oder mehrerer errechneter Fehlerabstandswerte, die für einen oder mehrere Hilfskompensationswerte berechnet worden sind, mit dem bei dem früheren oder aktuellen auf der Energieversorgungsleitung (30) aufgetretenen Fehler tatsächlich festgestellten Fehlerabstandswert und
- der Auswahl desjenigen Hilfskompensationswerts, dessen errechneter Fehlerabstandswert die kleinste Abweichung von dem tatsächlich festgestellten Fehlerabstandswert aufweist, als den ermittelten Kompensationswert.

9. Distanz- oder Kompensationswertermittlungsverfahren nach einem der voranstehenden Ansprüche,
**dadurch gekennzeichnet, dass** die zurückgerechneten Kompensationswerte für den Fall eines einphasigen Leiter-Erde-Fehlers im x-ten Phasenleiter der Energieversorgungsleitung (30) jeweils derart berechnet werden, dass die Abweichung zwischen dem korrespondierenden Fehlerabstandswert m und dem tatsächlich festgestellten Fehlerabstandswert Msoll minimal ist bzw. gilt:

$$m = \frac{1}{|Z|} \cdot \frac{\mathrm{Im}\left\{Ulx \cdot \left[Is \cdot e^{j\delta}\right]^*\right\}}{\mathrm{Im}\left\{\dfrac{Z}{|Z|} \cdot (Ilx - k0 \cdot Ie) \cdot \left[Is \cdot e^{j\delta}\right]^*\right\}} \overset{!}{=} Msoll$$

wobei bezeichnet:

- m den jeweiligen errechneten Fehlerabstandswert für den jeweiligen Hilfskompensationswert $\delta$ in Form eines prozentualen Anteils an der Gesamtlänge L des überwachten Leitungsabschnitts (20),
- Ilx den Leiterstrom als Zeigergröße im x-ten Phasenleiter der Energieversorgungsleitung (30),
- Ulx die Leiter-Erde-Spannung des x-ten Phasenleiters der Energieversorgungsleitung (30) als Zeigergröße,
- Z die Leitungsimpedanz des überwachten Leitungsabschnitts (20) der elektrischen Energieversorgungsleitung (30),
- Is einen Ersatzstrom,
- k0 einen für die elektrische Energieversorgungsleitung (30) charakteristischen Erdanpassungsfaktor und
- Msoll den tatsächlich festgestellten Fehlerabstandswert in Form eines prozentualen Anteils an der Gesamtlänge L des überwachten Leitungsabschnitts (20).

10. Distanz- oder Kompensationswertermittlungsverfahren nach einem der voranstehenden Ansprüche, **dadurch gekennzeichnet, dass** die zurückgerechneten Kompensationswerte Fehlerabstandswerte für den Fall eines Leiter-Leiter-Fehlers zwischen dem x-ten und y-ten Phasenleiter der Energieversorgungsleitung (30) jeweils derart berechnet werden, dass die Abweichung zwischen dem korrespondierenden Fehlerabstandswert m und dem tatsächlich festgestellten Fehlerabstandswert Msoll minimal ist bzw. gilt:

$$m = \frac{1}{|Z|} \cdot \frac{\mathrm{Im}\left\{Ulxy \cdot \left[Is \cdot e^{j\delta}\right]^*\right\}}{\mathrm{Im}\left\{\dfrac{Z}{|Z|} \cdot (Ilx - Ily) \cdot \left[Is \cdot e^{j\delta}\right]^*\right\}} \overset{!}{=} Msoll$$

wobei bezeichnet:

- m den jeweiligen errechneten Fehlerabstandswert für den jeweiligen Hilfskompensationswert $\delta$ in Form eines prozentualen Anteils an der Gesamtlänge L des überwachten Leitungsabschnitts (20),
- Ilx den Leiterstrom als Zeigergröße im x-ten Phasenleiter der Energieversorgungsleitung (30),
- Ily den Leiterstrom als Zeigergröße im y-ten Phasenleiter der Energieversorgungsleitung (30),
- Ulxy die Leiter-Leiter-Spannung als Zeigergröße zwischen dem x-ten und y-ten Phasenleiter der Energieversorgungsleitung (30),
- Z die Leitungsimpedanz des überwachten Leitungsabschnitts (20) der elektrischen Energieversorgungsleitung (30),
- Is einen Ersatzstrom, der sich berechnet gemäß ??? und
- Msoll den tatsächlich festgestellten Fehlerabstandswert in Form eines prozentualen Anteils an der Gesamtlänge L des überwachten Leitungsabschnitts (20).

11. Kompensationswertbestimmungseinrichtung (110) zum Ermitteln zumindest eines Kompensationswertes für ein Distanzschutzverfahren nach einem der voranstehenden Ansprüche oder ein Distanzschutzgerät, das ein Distanzschutzverfahren nach einem der voranstehenden Ansprüche ausführen kann, wobei diese derart ausgestaltet ist, dass sie den zumindest einen Kompensationswert anhand von Messdaten, die bei einem früheren auf der Energieversorgungsleitung (30) aufgetretenen Fehler erfasst und gespeichert worden sind oder einem aktuellen auf der Energieversorgungsleitung (30) aufgetretenen Fehler erfasst werden, ermittelt, **dadurch gekennzeichnet, dass** der Kompensationswert ermittelt wird

- durch einen Vergleich einer errechneten Fehlereigenschaft, die für einen oder mehrere Hilfskompensationswerte berechnet worden ist, mit der bei dem früheren oder aktuellen auf der Energieversorgungsleitung (30) aufgetretenen Fehler tatsächlich festgestellten Fehlereigenschaft und
- der Auswahl desjenigen Hilfskompensationswerts, dessen Fehlereigenschaft die kleinste Abweichung von der tatsächlich festgestellten Fehlereigenschaft aufweist, als ermittelter Kompensationswert.

12. Distanzschutzgerät (10),
**dadurch gekennzeichnet, dass** dieses eine Kompensationswertbestimmungseinrichtung (110) nach Anspruch 11 aufweist.

## Claims

1. Distance protection method for monitoring a line section (20) of an electrical power supply line (30), in which

   - current and voltage values (I, U) are measured and an impedance or reactance value (X) of the power supply line (30) is determined using at least one compensation value ($\delta 1$, $\delta 2$), and
   - a fault signal (FS) is generated when the impedance or reactance value (X) meets a predetermined trigger criterion, wherein

   a back-calculated compensation value which has been determined on the basis of measurement data which have been acquired in the case of a previous fault occurring on the power supply line (30) or a current fault occurring on the power supply line (30) is used as the at least one compensation value (61, $\delta 2$) or as at least one of the compensation values (61, $\delta 2$), **characterized in that**
   the at least one back-calculated compensation value ($\delta 1$, $\delta 2$) or at least one of the back-calculated compensation values has been determined

   - by comparing a calculated fault characteristic which has been calculated for one or more auxiliary compensation values ($\delta 1i$, $\delta 2i$) with the fault characteristic actually detected in the previous or current fault occurring on the power supply line (30), and
   - by selecting the auxiliary compensation value (61i, $\delta 2i$) whose fault characteristic has the smallest deviation from the actually detected fault characteristic as the back-calculated compensation value to be used in the future.

2. Distance protection method according to any one of the preceding claims,
   **characterized in that**
   the at least one back-calculated compensation value ($\delta 1$, $\delta 2$) or at least one of the back-calculated compensation values has been determined

   - by means of an iteration method in which a respective auxiliary compensation value ($\delta 1i$, $\delta 2i$) is determined for each iteration step in the context of iteration steps, and
   - the auxiliary compensation value (61i, $\delta 2i$) whose fault characteristic has the smallest deviation from the actually detected fault characteristic is determined as the iteration result and this iteration result is further used as the back-calculated compensation value to be used in the future.

3. Distance protection method according to any one of the preceding claims,
   **characterized in that**
   the at least one back-calculated compensation value ($\delta 1$, $\delta 2$) or at least one of the back-calculated compensation values has been determined

   - by comparing one or more calculated fault distance values ($m(\delta 1i)$, $m(\delta 2i)$) which have been calculated for one or more auxiliary compensation values ($\delta 1i$, $\delta 2i$) with the fault distance value (Msoll) actually detected in the previous or current fault occurring on the power supply line (30), and
   - by selecting the auxiliary compensation value whose calculated fault distance value has the smallest deviation from the actually detected fault distance value as the back-calculated compensation value to be used in the future.

4. Distance protection method according to any one of the preceding claims,
   **characterized in that**
   the measured data which have been acquired and stored in the case of a previous or current fault occurring on the power supply line (30) are taken as a basis for determining at least two back-calculated compensation values, namely a first compensation value referred to the zero phase-sequence system and a second compensation value referred to the negative phase-sequence system.

5. Distance protection method according to Claim 4,
**characterized in that**
the first and second back-calculated compensation values have each been determined

- by comparing a calculated fault characteristic which has been calculated for one or more auxiliary compensation values with the fault characteristic actually detected in the previous or current fault occurring on the power supply line (30), and
- by selecting the auxiliary compensation value whose fault characteristic has the smallest deviation from the actually detected fault characteristic as the back-calculated compensation value to be used in the future.

6. Distance protection method according to any one of the preceding claims,
**characterized in that**
the first and second back-calculated compensation values have each been determined

- by comparing one or more calculated fault distance values which have been calculated for one or more auxiliary compensation values with the fault distance value actually detected in the previous or current fault occurring on the power supply line (30), and
- by selecting the auxiliary compensation value whose calculated fault distance value has the smallest deviation from the actually detected fault distance value as the back-calculated compensation value to be used in the future.

7. Compensation value determination method for determining at least one compensation value for a distance protection method according to any one of the preceding claims,
wherein

the at least one compensation value is determined on the basis of measurement data which have been acquired in the case of a previous fault occurring on the power supply line (30) or which are acquired in the case of a current fault occurring on the power supply line (30), **characterized in that**
the compensation value is determined

- by comparing a calculated fault characteristic which has been calculated for one or more auxiliary compensation values with the fault characteristic actually detected in the previous or current fault occurring on the power supply line (30), and
- selecting the auxiliary compensation value whose fault characteristic has the smallest deviation from the actually detected fault characteristic as the determined compensation value.

8. Compensation value determination method according to any one of the preceding Claims 6 to 7,
**characterized in that**
the compensation value is determined

- by comparing one or more calculated fault distance values which have been calculated for one or more auxiliary compensation values with the fault distance value actually detected in the previous or current fault occurring on the power supply line (30), and
- selecting the auxiliary compensation value whose calculated fault distance value has the smallest deviation from the actually detected fault distance value as the determined compensation value.

9. Distance or compensation value determination method according to any one of the preceding claims,
**characterized in that**
the back-calculated compensation values for the case of a single-phase conductor-earth fault in the x-th phase conductor of the power supply line (30) are each calculated in such a way that the deviation between the corresponding fault distance value m and the actually detected fault distance value Msoll is minimal or the following holds true:

$$m = \frac{1}{|Z|} \cdot \frac{\mathrm{Im}\left\{Ulxy \cdot \left[Is \cdot e^{j\delta}\right]^*\right\}}{\mathrm{Im}\left\{\dfrac{Z}{|Z|} \cdot (Ilx - Ily) \cdot \left[Is \cdot e^{j\delta}\right]^*\right\}} \overset{!}{=} Msoll$$

wherein:

- m denotes the respective calculated fault distance value for the respective auxiliary compensation value $\delta$ in the form of a percentage of the total length L of the monitored line section (20),
- Ilx denotes the conductor current as a phasor variable in the x-th phase conductor of the power supply line (30),
- Ulx denotes the conductor-earth voltage of the x-th phase conductor of the power supply line (30) as a phasor variable,
- Z denotes the line impedance of the monitored line section (20) of the electrical power supply line (30),
- Is denotes a replacement current,
- k0 denotes an earth adaptation factor characteristic of the electrical power supply line (30), and
- Msoll denotes the actually detected fault distance value in the form of a percentage of the total length L of the monitored line section (20).

10. Distance or compensation value determination method according to any one of the preceding claims, **characterized in that**
the back-calculated compensation values fault distance values for the case of conductor-conductor fault in the x-th and y-th phase conductors of the power supply line (30) are each calculated in such a way that the deviation between the corresponding fault distance value m and the actually detected fault distance value Msoll is minimal or the following holds true:

$$m = \frac{1}{|Z|} \cdot \frac{\mathrm{Im}\left\{Ulx \cdot \left[Is \cdot e^{j\delta}\right]^*\right\}}{\mathrm{Im}\left\{\dfrac{Z}{|Z|} \cdot (Ilx - k0 \cdot Ie) \cdot \left[Is \cdot e^{j\delta}\right]^*\right\}} \overset{!}{=} Msoll$$

wherein:

- m denotes the respective calculated fault distance value for the respective auxiliary compensation value $\delta$ in the form of a percentage of the total length L of the monitored line section (20),
- Ilx denotes the conductor current as a phasor variable in the x-th phase conductor of the power supply line (30),
- Ily denotes the conductor current as a phasor variable in the y-th phase conductor of the power supply line (30),
- Ulxy denotes the conductor-conductor voltage as the phasor variable between the x-th and y-th phase conductors of the power supply line (30),
- Z denotes the line impedance of the monitored line section (20) of the electrical power supply line (30),
- Is denotes a replacement current calculated according to ??? and
- Msoll denotes the actually detected fault distance value in the form of a percentage of the total length L of the monitored line section (20).

11. Compensation value ascertaining device (110) for determining at least one compensation value for a distance protection method according to any one of the preceding claims or a distance protection unit which can carry out a distance protection method according to any one of the preceding claims, wherein
said device or unit is designed in such a way that it determines the at least one compensation value on the basis of measurement data which have been detected and stored in the case of a previous fault occurring on the power supply line (30) or a current fault occurring on the power supply line (30), **characterized in that** the compensation value is determined

- by comparing a calculated fault characteristic which has been calculated for one or more auxiliary compensation values with the fault characteristic actually detected in the previous or current fault occurring on the power supply line (30), and
- selecting the auxiliary compensation value whose fault characteristic has the smallest deviation from the actually detected fault characteristic as the determined compensation value.

12. Distance protection unit (10),
    **characterized in that**
    said unit comprises a compensation value ascertaining device (110) according to Claim 11.


**Revendications**

1. Procédé de protection de distance pour le contrôle d'un tronçon (20) d'une ligne (30) d'alimentation en énergie électrique, dans lequel

   - on mesure des valeurs (I, U) de courant et de tension et, en tirant partie d'au moins une valeur ($\delta$1, $\delta$2) de compensation, on détermine une valeur (X) d'impédance ou de réactance de la ligne (30) d'alimentation en énergie et
   - on produit un signal (FS) de défaut, si la valeur (X) d'impédance ou de réactance satisfait un critère de déclenchement donné à l'avance,
   dans lequel

   on utilise comme la au moins une valeur ($\delta$1, $\delta$2) de compensation ou comme la au moins l'une des valeurs ($\delta$1, $\delta$2) de compensation, une valeur de compensation recalculée, qui a été déterminée à l'aide de données de mesure, qui ont été saisies lors d'un défaut antérieur apparu sur la ligne (30) d'alimentation en énergie ou qui sont saisies lors d'un défaut en cours apparaissant sur la ligne (30) d'alimentation en énergie, **caractérisé en ce que**
   l'on a déterminé la au moins une valeur ($\delta$1, $\delta$2) de compensation recalculée ou la au moins l'une des valeurs de compensation recalculées

   - en comparant une propriété de défaut calculée, qui a été calculée pour une ou pour plusieurs valeurs ($\delta$1i, $\delta$2i) de compensation auxiliaires, à la propriété de défaut constatée réellement lors du défaut antérieur apparu ou apparaissant actuellement sur la ligne (30) d'alimentation en énergie et
   - par le choix de la valeur ($\delta$1i, $\delta$2i) de compensation auxiliaire, dont la propriété d'erreur a l'écart le plus petit à la propriété d'erreur constatée réellement, comme valeur de compensation recalculée à utiliser à l'avenir.

2. Procédé de protection de distance suivant l'une des revendications précédentes,
   **caractérisé en ce que**
   l'on a déterminé la au moins une valeur ($\delta$1, $\delta$2) de compensation recalculée ou au moins l'une des valeurs de compensation recalculée

   - par un procédé d'itération, dans lequel on détermine, dans le cadre de stades d'itération, pour chaque stade d'itération respectivement une valeur ($\delta$1i, $\delta$2i) de compensation auxiliaire, et
   - on détermine comme résultat de l'itération, la valeur ($\delta$1i, $\delta$2i) de compensation auxiliaire, dont la propriété de défaut a l'écart le plus petit à la propriété de défaut constatée réellement, et on utilise ce résultat de l'itération, comme valeur de compensation recalculée à utiliser à l'avenir.

3. Procédé de protection de distance suivant l'une des revendications précédentes,
   **caractérisé en ce que**
   l'on a déterminé la au moins une valeur ($\delta$1, $\delta$2) de compensation recalculée ou au moins l'une des valeurs de compensation recalculée

   - par une comparaison d'une ou de plusieurs valeurs (m($\delta$1i), m($\delta$2i)) de distance de défaut calculées, qui ont été calculées pour l'une ou pour plusieurs valeurs ($\delta$1i, $\delta$2i) de compensation auxiliaires, à la valeur (Msoll) de distance de consigne constatée réellement, lors d'un défaut antérieur apparu ou apparaissant actuellement sur la ligne (30) d'alimentation en énergie, et
   - par la sélection de la valeur de compensation auxiliaire, dont la valeur de distance de défaut calculée a l'écart le plus petit à la valeur de distance de défaut constatée réellement, comme valeur de compensation recalculée à utiliser à l'avenir.

4. Procédé de protection de distance suivant l'une des revendications précédentes,

**caractérisé en ce que**,
à l'aide des données de mesure, qui ont été saisies et mises en mémoire, lors d'un défaut antérieur apparu ou apparaissant actuellement sur la ligne (30) d'alimentation en énergie, on détermine au moins deux valeurs de compensation recalculées, à savoir une première valeur de compensation rapportée au système homopolaire et une deuxième valeur de compensation rapportée au système inverse.

5. Procédé de protection de distance suivant la revendication 4,
**caractérisé en ce que**
l'on a déterminé la première et la deuxième valeurs de compensation recalculées respectivement

- par une comparaison d'une propriété de défaut calculée, qui a été calculée pour une ou pour plusieurs valeurs de compensation auxiliaires, à la propriété de défaut constatée réellement, lors d'un défaut antérieur apparu ou apparaissant actuellement sur la ligne (30) d'alimentation en énergie et
- par la sélection de la valeur de compensation auxiliaire, dont la propriété de défaut a l'écart le plus petit à la propriété de défaut constatée réellement, comme valeur de compensation recalculée à utiliser à l'avenir.

6. Procédé de protection de distance suivant l'une des revendications précédentes,
**caractérisé en ce que**
l'on a déterminé respectivement la première et la deuxième valeurs de compensation recalculées

- par une comparaison d'une ou de plusieurs valeurs de distance de défaut calculées, qui ont été calculées pour une ou plusieurs valeurs de compensation auxiliaires, à la valeur de distance de défaut constatée réellement lors d'un défaut antérieur apparu ou apparaissant actuellement sur la ligne (30) d'alimentation en énergie et
- par sélection de la valeur de compensation auxiliaire, dont la valeur de distance de défaut calculée a l'écart le plus petit à la valeur de distance de défaut constatée réellement, comme valeur de compensation recalculée à utiliser à l'avenir.

7. Procédé de détermination de valeur de compensation pour la détermination d'au moins une valeur de compensation pour un procédé de protection de distance suivant l'une des revendications précédentes,
dans lequel
on détermine la au moins une valeur de compensation à l'aide de données de mesure, qui ont été saisies lors d'un défaut antérieur apparu sur la ligne (30) d'alimentation en énergie ou lors d'un défaut apparaissant actuellement sur la ligne (30) d'alimentation en énergie, **caractérisé en ce que** l'on détermine la valeur de compensation

- par une comparaison d'une propriété de défaut calculée, qui a été calculée pour une ou pour plusieurs valeurs de compensation auxiliaires, à la propriété de défaut constatée réellement, lors d'un défaut antérieur apparu ou apparaissant actuellement sur la ligne (30) d'alimentation en énergie, et
- la sélection de la valeur de compensation auxiliaire, dont la propriété de défaut a l'écart le plus petit à la propriété de défaut constatée réellement, comme valeur de compensation déterminée.

8. Procédé de détermination de valeur de compensation suivant la revendication 6 à 7,
**caractérisé en ce que**
l'on détermine la valeur de compensation

- par une comparaison d'une ou de plusieurs valeurs de distance de défaut calculées, qui ont été calculées pour une ou pour plusieurs valeurs de compensation auxiliaires, à la valeur de distance de défaut constatée réellement, lors d'un défaut antérieur apparu ou apparaissant actuellement sur la ligne (30) d'alimentation en énergie et
- la sélection de la valeur de compensation auxiliaire, dont la valeur de distance de défaut calculée a l'écart le plus petit à la valeur de distance de défaut constatée réellement, comme valeur de compensation déterminée.

9. Procédé de détermination de valeur de distance ou de compensation suivant l'une des revendications précédentes,
**caractérisé en ce que**
pour les valeurs de compensation recalculées, dans le cas d'un défaut conducteur-terre monophasé, dans le x-ième conducteur de phase de la ligne (30) d'alimentation en énergie, on calcule respectivement, de manière à ce que l'écart entre la valeur $m$ de distance de défaut correspondante et la valeur $Msoll$ de distance de défaut constatée réellement, soit minimum et, respectivement à avoir :

$$m = \frac{1}{|Z|} \cdot \frac{\text{Im}\left\{Ulx \cdot \left[Is \cdot e^{j\delta}\right]^*\right\}}{\text{Im}\left\{\dfrac{Z}{|Z|} \cdot (Ilx - k0 \cdot Ie) \cdot \left[Is \cdot e^{j\delta}\right]^*\right\}} \overset{!}{=} Msoll$$

dans laquelle il est désigné :

- par m la valeur de distance de défaut calculée respective pour la valeur δ de compensation auxiliaire respective sous la forme d'une proportion en pourcentage de la longueur L totale du tronçon (20) de ligne contrôlé,
- par Ilx le courant de ligne comme grandeur vectorielle dans le x-ième conducteur de phase de la ligne (30) d'alimentation en énergie,
- par Ulx la tension conducteur-terre du x-ième conducteur de phase de la ligne (30) d'alimentation en énergie comme grandeur vectorielle,
- par Z l'impédance de ligne du tronçon (20) de ligne contrôlé de la ligne (30) d'alimentation en énergie électrique,
- par Is un courant de remplacement,
- par k0 un facteur d'adaptation à la terre caractéristique de la ligne (30) d'alimentation en énergie électrique et
- par Msoll la valeur de distance de défaut constatée réellement sous la forme d'une proportion en pourcentage de la longueur L totale du tronçon (20) de ligne contrôlé.

10. Procédé de détermination de valeur de distance ou de compensation suivant l'une des revendications précédentes, **caractérisé en ce que**
l'on calcule respectivement les valeurs de compensation, les valeurs de distance de défaut recalculées, dans le cas d'un défaut ligne-ligne entre le x-ième et le y-ième conducteur de phase de la ligne (30) d'alimentation en énergie, de manière à ce que l'écart entre la valeur m de distance de défaut correspondante et la valeur Msoll de distance de défaut constatée réellement soit minimum et respectivement de manière à avoir :

$$m = \frac{1}{|Z|} \cdot \frac{\text{Im}\left\{Ulxy \cdot \left[Is \cdot e^{j\delta}\right]^*\right\}}{\text{Im}\left\{\dfrac{Z}{|Z|} \cdot (Ilx - Ily) \cdot \left[Is \cdot e^{j\delta}\right]^*\right\}} \overset{!}{=} Msoll$$

dans lequel il est désigné :

- par m la valeur de distance de défaut calculée respective pour la valeur δ de compensation auxiliaire respective sous la forme d'une proportion en pourcentage de la longueur L totale du tronçon (20) de ligne contrôlé,
- par Ilx le courant de ligne comme grandeur vectorielle dans le x-ième conducteur de phase de la ligne (30) d'alimentation en énergie,
- par Ily le courant de conducteur comme grandeur vectorielle dans le y-ième conducteur de phase de la ligne (30) d'alimentation en énergie,
- par Ulxy la tension conducteur-conducteur comme grandeur vectorielle entre le x-ième et le y-ième conducteur de phase de la ligne (30) d'alimentation en énergie,
- par Z l'impédance de ligne du tronçon (20) de ligne contrôlé de la ligne (30) d'alimentation en énergie électrique,
- par Is un courant de remplacement, qui se calcule suivant ??? et
- par Msoll la valeur de distance de défaut constatée réellement sous la forme d'une proportion en pourcentage de la longueur L totale du tronçon (20) de ligne contrôlé.

11. Dispositif (110) de détermination de valeurs de compensation pour la détermination d'au moins une valeur de compensation pour un procédé de protection de distance suivant l'une des revendications précédentes ou un appareil de protection de distance, qui peut exécuter un procédé de protection de distance suivant l'une des revendications précédentes,
dans lequel
celui-ci est conformé, de manière à déterminer à l'aide de données de mesure, qui ont été saisies et mises en mémoire lors d'un défaut antérieur apparu sur la ligne (30) d'alimentation en énergie ou sont saisies lors d'un défaut apparaissant actuellement sur la ligne (30) d'alimentation en énergie, **caractérisé en ce que** l'on détermine la valeur de compensation,

- par une comparaison d'une propriété de défaut calculée, qui a été calculée pour une ou pour plusieurs valeurs de compensation auxiliaires, à la propriété de défaut constatée réellement lors d'un défaut antérieur apparu ou apparaissant actuellement sur la ligne (30) d'alimentation en énergie et
- la sélection de la valeur de compensation auxiliaire, dont la propriété de défaut a l'écart le plus petit à la propriété de défaut constatée réellement, comme valeur de compensation déterminée.

12. Appareil (10) de protection de distance,
**caractérisé en ce que**
celui-ci a un dispositif (110) de détermination de valeur de compensation suivant la revendication 11.

FIG 1

# FIG 2

EP 3 964 847 B1

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 2937704 B1

- EP 2083278 A1